# FASCICULE DE BREVET EUROPEEN

(11) **EP 0 479 680 B1**
(45) Date de publication et mention de la délivrance du brevet: **17.05.1995**
(21) Numéro de dépôt: 91402639.8
(22) Date de dépôt: 03.10.1991
(51) Int. Cl.: F16L 59/02, B64G 1/58, A62C 3/00

(54) **Dispositif de protection thermique, notamment pour la protection de la boîte noire d'un aéronef**
Temperaturschutzvorrichtung, insbesondere zum Schutz des Flugschreibers eines Flugzeuges
Thermal protection device, in particular for the protection of an airplane "black box"

(30) Priorité: 05.10.1990 FR 9012303
(43) Date de publication de la demande: 08.04.1992
(73) Titulaire: SOCIETE DE FABRICATION D'INSTRUMENTS DE MESURE (S.F.I.M.), F-91301 Massy (FR)
(72) Inventeur: Ducassou, Didier, F-91120 Palaiseau (FR)
(74) Mandataire: Schrimpf, Robert

(56) Documents cités:
- FR-A- 2 464 227
- FR-A- 2 512 808
- FR-A- 2 625 793
- GB-A- 1 498 177

## Description

L'invention concerne un dispositif de protection thermique d'un matériel sensible aux agressions thermiques, notamment pour la protection du matériel électronique de la "boîte noire" d'un aéronef.

La protection thermique du matériel de la boîte noire d'un aéronef est difficile à réaliser du fait que cette protection non seulement doit être efficace contre le feu et les températures élevées au moins pendant un temps minimal déterminé mais aussi doit pouvoir supporter des conditions très sévères comme celles créées par un choc sur la terre ou sur l'eau après une chute de plusieurs milliers de mètres et une immersion en eau profonde.

On a déjà proposé d'obtenir cette protection en plaçant le matériel sensible dans un récipient et en réalisant entre le matériel et le récipient un écran d'isolation thermique contenant un matériau susceptible de libérer de l'eau de cristallisation sous l'effet d'une agression thermique (GB-A-1498177).

Certains matériaux en effet contiennent de l'eau de structure qu'ils sont capables de libérer sous l'effet d'une élévation de température. C'est le cas notamment des matériaux décrits dans la publication du certificat d'utilité français N° 2 512 808 qui contiennent de l'eau piégée dans une structure zéolithique. Cette publication indique que cette eau de constitution peut s'évaporer et contribuer ainsi à augmenter la capacité d'isolation des matériaux décrits qui sont décrits comme étant des mousses de "géopolymères".

Il a paru intéressant d'utiliser de tels matériaux comme matière isolante dans le dispositif précité où le materiel sensible est placé dans un récipient.

Toutefois, une telle application pose de nombreux problèmes en raison de l'épaisseur de matière isolante qui serait nécessaire pour assurer l'isolation désirée, et des conditions sévères (écrasement, poinçonnement, immersion) auxquelles la mousse de géopolymère doit résister.

Les matériaux à structure de mousse présentent notamment une fragilité de surface qui serait rédhibitoire dans l'application envisagée ci-dessus.

De fait, la simple interposition d'un écran en matière à structure zeolithique entre le matériel sensible et un récipient ne peut pas constituer une solution acceptable au problème posé.

On a maintenant déterminé qu'il est cependant possible d'obtenir des résultats très satisfaisants au moyen d'un dispositif tel que défini dans la revendication 1.

L'écran métallique, en réfléchissant vers l'extérieur du complexe une partie de l'énergie thermique incidente, en cas d'exposition au feu, permet de réduire l'épaisseur de la masse zéolithique.

Le feutre, autre composant essentiel du complexe de l'invention, réalise, de façon étonnante, une liaison intime parfaite entre la masse zéolithique et l'écran métallique.

Un tel complexe constitue ainsi un écran thermique efficace dans l'application à la protection d'une boîte noire, ainsi que pour toute application similaire (protection d'un matériel électronique) et, à fortiori, pour des applications moins sévères.

On décrira ci-après, à titre d'exemple non limitatif, une réalisation d'un dispositif conforme à l'invention, en référence aux figures du dessin joint, la description et les figures faisant apparaître d'autres particularités de la présente invention.

Sur les figures :
- la figure 1 est une vue partielle en coupe du dispositif selon l'invention ;
- la figure 2 est une vue d'ensemble en coupe du dispositif de protection, et
- la figure 3 est un graphique relatif à un essai thermique de l'écran.

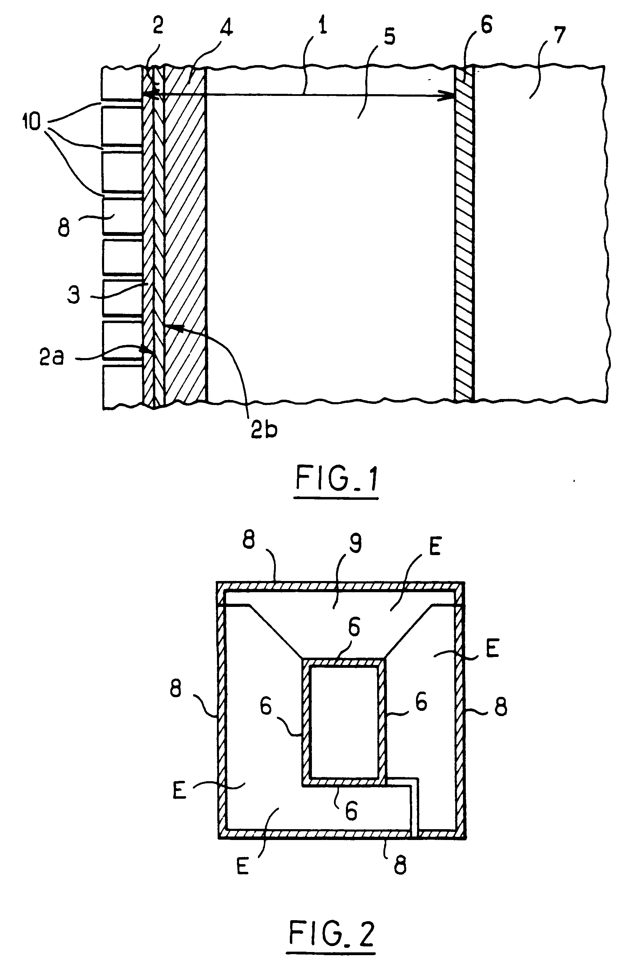

Le dispositif de protection représenté sur la figure 1 comprend une boîte interne dont la paroi est représenté en 6, placée dans le récipient dont la paroi est représentée en 8, l'intervalle entre ces deux parois étant rempli par un écran composite E représenté en coupe dans son épaisseur, laquelle est indiquée par la double flèche 1, en vue agrandie.

Cet écran composite est constitué de trois couches, à savoir :
- une paroi 2, de préférence une feuille métallique de quelques dixièmes de mm d'épaisseur, dont la face 2a tournée vers l'extérieur du complexe a été polie puis revêtue par un dépôt chimique ou par évaporation sous vide d'un métal 3 offrant un coefficient de réflexion élevé sur une plage de longueurs d'ondes importante. Les caractéristiques physico-chimiques du dépôt et de la feuille métallique sont choisies en concordance avec l'environnement thermique, c'est-à-dire de façon à avoir un point de fusion élevé et une bonne stabilité à l'oxydation ;
- un feutre réfractaire en céramique 4, de 2 à 3 mm d'épaisseur, collé sur la face non polie 2b de la paroi réfléchissante, au moyen d'une colle silicone ou autre. Ce feutre est composé de fibres d'alumine (75%) et de silice fondue de haute pureté de façon à présenter une stabilité thermique élevée ;
- une masse durcie 5 d'une matière minérale contenant de l'eau zéolithique, obtenue par polycondensation in-situ, contre le feutre 4 d'une composition zéolithique de silico-aluminate. De telles compositions sont décrites par exemple dans le brevet français publié sous le N° 2 464 227 et sont vendues sous l'appellation GEOPOLYMITE par la société GEOPOLYMERE-France.

On peut se référer, à titre documentaire, pour la connaissance de ces matières, aux publications d'autres publications de brevets et d'articles de Monsieur J. DAVIDOVITS, notamment "Synthesis of new high-temperature geo-polymers for reinforced plastics/composites" (Society of Plastics Engineers, Inc, PACTEC'79), "Processing and applications of ultra-high temperature, inorganic matrix resin for cast composite structures..." (PACTEC'83), et à la notice "Les matériaux GEOPOLYMERES (octobre 1986).

Ces publications décrivent des alumino-silicates de sodium ou de potassium qui, en milieu alcalin, se polycondensent et forment un polymère minéral tridimensionnel ayant une structure analogue à celle des zéolithes naturelles.

Selon la présente invention, on réalise cette polycondensation in-situ contre le feutre en sorte que la composition pâteuse de départ imprègne plus ou moins le feutre, ce qui évitera tout vide entre l'écran métallique et le géopolymère durci. On notera que le feutre minéral, outre cette fonction essentielle qui assure la protection de la surface de la masse de géopolymère, a aussi pour fonction d'empêcher un contact direct entre le milieu réactionnel basique et l'écran métallique susceptible d'être attaqué par un tel milieu.

On donne la préférence aux géopolymères de type sodique (polysialate de sodium) qui assure la constitution d'une quantité importante d'eau zéolithique.

De préférence, on associe à cette matrice minérale des liquides organiques susceptibles de générer des fonctions hydroxyles sous l'action de la chaleur, par exemple du glycol, dans une proportion de préférence comprise entre 5 et 10% en poids de la matrice minérale.

Il est également avantageux, pour renforcer mécaniquement la matrice, de lui incorporer des fibres, par exemple des fibres d'alumine courtes (1 à 2 mm) comme celles commercialisées sous la dénomination SAFFIL par la société ICI.

La proportion de fibres incorporées à la matrice peut être dans la gamme de 5 à 50% environ en poids, une proportion de 10% donnant déjà des résultats très satisfaisants.

La protection thermique obtenue est stable à basse températue (inférieure à 0°C), sans risque de formation de glace et ne nécessite pas d'effectuer l'étanchéité du système à protéger car l'eau libre, c'est-à-dire l'eau extérieure au réseau, a été éliminée par séchage lors de la phase de polymérisation de la matrice.

De préférence, on réalise la réaction contre le feutre après avoir collé le feutre à l'écran réflecteur métallique mais il n'est pas exclu de réaliser d'abord la réaction dans un moule sur le feutre puis de coller le feutre à l'écran métallique.

La boîte interne 6 est par exemple une boîte en acier 6 contenant un matériel électronique 7.

De fait, on procède généralement en deux étapes (figure 2). Dans un premier stade, on place la boîte 6 dans le récipient 8 dont on a tapissé le fond et les côtés avec l'écran réflecteur 2,3 et le feutre 4 collé à l'écran et on verse le mélange réactionnel dans l'espace intersticiel entre le feutre et la boîte, en réservant l'espace qui sera ultérieurement fermé par le couvercle 9 du récipient. Ce couvercle 9 est réalisé à part et rapporté ensuite à sa place. Le couvercle 9 comporte lui aussi un écran selon l'invention.

La référence 11 désigne sur la figure 2 le passage des conducteurs électriques de la boîte noire.

La paroi du récipient est percée de micro-trous 10 (figure 1) destinés, en cas d'incendie, à l'évacuation de la vapeur produite par l'évaporation de l'eau zéolithique de la matière 5.

Sous l'action d'une agression thermique, la matière minérale intervient comme stabilisateur thermique du fait que l'eau zéolithique se libère à partir de 200°C, créant ainsi un environnement thermique stabilisé à 100°C dont la durée est fonction de la quantité d'eau zéolithique.

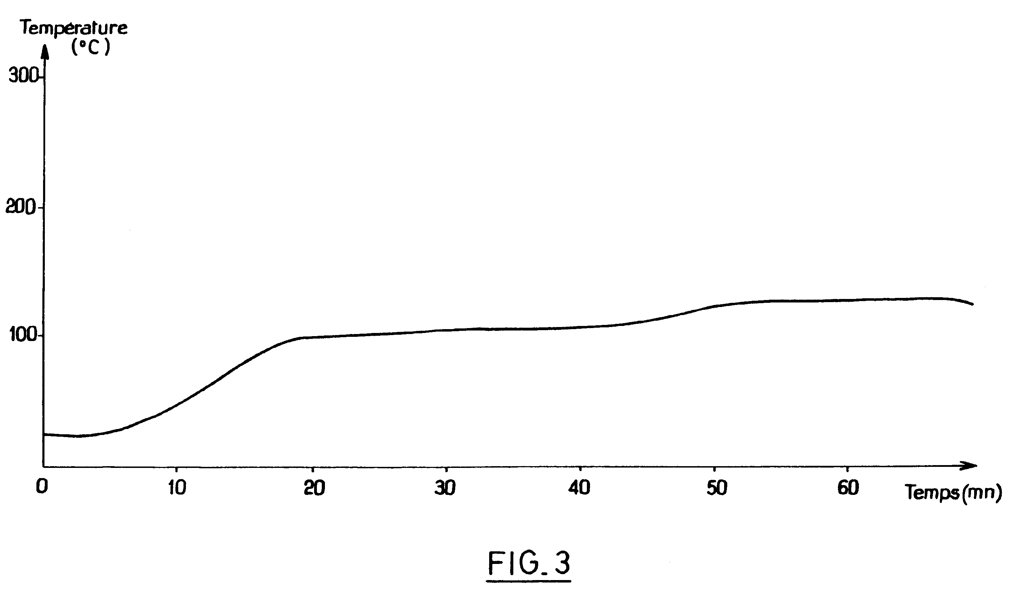

La figure 3 est un graphique montrant les résultats obtenus dans le cas de l'exemple décrit plus haut, lors d'une exposition à des flammes de 1100°C produites par deux chalumeaux dont le flux total est de 150 Kw/m².

On constate que la température ne dépasse pas 110°C après 30 mn d'exposition et reste inférieure à 130°C après l'arrêt des flammes, ceci pour une épaisseur de protection thermique de 15 mm.

L'invention n'est pas limitée au choix d'un "géopolymère" comme matière contenant de l'eau zéolithique et s'étend à l'emploi de toute matière minérale déterminant une matrice tri-dimensionnelle contenant de l'eau piégée sous forme zéolithique.

## Revendications

1. Dispositif de protection thermique d'un matériel sensible aux agressions thermiques, ce dispositif comprenant un récipient (8) qui entoure le matériel (7) et un écran E d'isolation thermique placé entre le matériel et le récipient (8) et contenant un matériau susceptible de libérer de l'eau de cristallisation sous l'effet d'une agression thermique, caractérisé en ce que cet écran remplit un intervalle entre ledit recipient (8) et une boîte (6) contenant ledit matériel et en ce que cet, écran E comprend une paroi métallique (2) dont la face (2a) tournée vers le récipient est réfléchissante (2,3), un feutre réfractaire (4) collé au dos de cette paroi et une masse solide minérale (5) contenant de l'eau zéolithique qui a été préparée par durcissement contre le feutre d'une matière de départ fluide dont une partie a imprégné le feutre, ladite masse remplissant l'espace intersticiel entre le feutre (4) et la boîte (6).

2. Dispositif selon la revendication 1, caractérisé en ce que le feutre (4) est un feutre de céramique.

3. Dispositif selon la revendication 1 ou 2, caractérisé en ce que la masse solide minérale a été obtenue par polycondensation en milieu basique d'un alumino-silicate.

4. Dispositif selon la revendication 1 ou 2, caractérisé en ce que la masse solide minérale a été obtenue par polycondensation en milieu basique d'un alumino-silicate de sodium.

5. Dispositif selon l'une des revendications 1 à 4, caractérisé en ce que ladite masse solide minérale contient de 5 à 50% en poids de fibres, notamment des fibres d'alumine.

6. Dispositif selon l'une des revendications 1 à 5, caractérisé en ce que la paroi du récipient (8) comporte des microtrous pour l'évacuation de la vapeur produite par l'évaporation de l'eau zéolithique en cas d'exposition au feu.

7. Application d'un dispositif selon l'une des revendications 1 à 6 à la protection de la boîte noire d'un aéronef.

## Patentansprüche

1. Thermische Schutzvorrichtung für gegen thermische Beanspruchung empfindliches Gerät umfassend einen Behälter (8), der das Gerät (7) umgibt, sowie einen thermischen Isolationschirm (E), der zwischen dem Gerät und dem Behälter (8) angeordnet ist und einen Werkstoff enthält, der unter der Wirkung einer thermischen Beanspruchung entstandenes Kristallisationswasser freigeben kann, dadurch **gekennzeichet**, daß der Isolationschirm den Zwischenraum zwischen dem Behälter (8) und einem Kasten (6) ausfüllt, welcher das Gerät aufnimmt, und daß der Isolationschirm (E) eine metallische Wand (2) umfaßt, deren zum Behälteräußeren weisende Oberfläche (2a) reflektierend (2, 3) ist, wobei eine hitzebeständige Matte (4) auf den Rücken dieser Wand geklebt ist und eine feste mineralische Masse (5) enthaltend zeolithisches Wasser, die durch Aushärten auf der Matte eines Trennfluids aufbereitet ist, von der ein Anteil die Matte impregniert hat, den Zwischenraum zwischen der Matte (4) und dem Kasten (6) ausfüllt.

2. Vorrichtung nach Anspruch 1, dadurch **gekennzeichet**, daß die Matte (4) eine Keramikmatte ist.

3. Vorrichtung nach Anspruch 1 oder 2, dadurch **gekennzeichet**, daß die feste mineralische Masse durch Polykondensation eines Aluminium-Silikates in einem basischen Milieu erhalten ist.

4. Vorrichtung nach Anspruch 1 oder 2, dadurch **gekennzeichet**, daß die feste mineralische Masse durch Polykondensation in einem basischen Milieu eines Aluminium-Silikates von Natrium erhalten ist.

5. Vorrichtung nach einem der Ansprüche 1 bis 4, dadurch **gekennzeichet**, daß die genannte feste mineralische Masse 5 bis 50 Gewichtsprozent Fasern, insbesondere Aluminiumfasern, enthält.

6. Vorrichtung nach einem der Ansprüche 1 bis 5, dadurch **gekennzeichet**, daß die Wand des Behälters (8) Mikrolöcher zum Evakuieren von Dampf aufweist, der durch Verdampfen von zeolithischem Wasser dann erzeugt wird, wenn die Vorrichtung einem Brand ausgesetzt wird.

7. Anwendung einer Vorrichtung nach einem der Ansprüche 1 bis 6 zum Schutz des schwarzen Kastens eines Luftfahrzeuges.

## Claims

1. A thermal protection device for equipment that is sensitive to thermal aggression, the device comprising a receptacle (8) that surrounds the equipment (7) and a thermal insulation screen (E) placed between the equipment and the receptacle (8) and containing a material suitable for releasing crystallization water under the effect of thermal aggression, characterized in that the screen fills the gap between said receptacle (8) and a box (6) containing said equipment and in that said screen (E) comprises a metal wall (2) whose face (2a) facing the receptacle is reflecting (2, 3), a refractory felt (4) stuck to the back of said wall, and an inorganic solid mass (5) containing zeolitic water and that has been prepared by allowing an initially fluid material to set against the felt, a fraction thereof impregnating the felt, said mass filling the space between the felt (4) and the box (6).

2. A device according to claim 1, characterized in that the felt (4) is a ceramic felt.

3. A device according to claim 1 or 2, characterized in that the inorganic solid mass is obtained by polycondensation of an aluminosilicate in a basic medium.

4. A device according to claim 1 or 2, characterized in that the inorganic solid mass is obtained by polycondensation of a sodium alumino-silicate in a basic medium.

5. A device according to any one of claims 1 to 4, characterized in that said inorganic solid mass contains 5% to 50% by weight of fibers, in particular alumina fibers.

6. A device according to any one of claims 1 to 5, characterized in that the wall of the receptacle (8) includes microholes for exhausting steam produced by the evaporation of the zeolitic water in the event of exposure to fire.

7. Use of a device according to any one of claims 1 to 6 in protecting the black box of an aircraft.
